# FASCICULE DE BREVET EUROPEEN

(11) **EP 2 393 085 B1**
(45) Date de publication et mention de la délivrance du brevet: **27.12.2017**
(21) Numéro de dépôt: 11168474.2
(22) Date de dépôt: 01.06.2011
(51) Int. Cl.: G11B 33/14, G11B 33/12, G08B 13/196, H05K 9/00, G06F 1/18

(54) **Cartouche de stockage amovible pour environnement électromagnetique sévère**
Abnehmbar Speicherkassette für harsche elektromagnetische Umgebung
Removable storage cartridge for harsh electomagnetic environment

(30) Priorité: 04.06.2010 FR 1002376
(43) Date de publication de la demande: 07.12.2011
(73) Titulaire: Thales, 92400 Courbevoie (FR)
(72) Inventeur: Portal, Serge, 91120 Palaiseau (FR); Laforet, Jean-Jacques, 91070 Bondoufle (FR); Leduc, Thierry, 91470 Angervilliers (FR)
(74) Mandataire: Collet, Alain

(56) Documents cités:
- US-A- 5 144 661
- US-A- 5 269 698
- US-A- 5 356 300
- US-A1- 2004 032 711
- US-B1- 6 292 326

## Description

L'invention se situe dans le domaine du stockage de données de vidéosurveillance, notamment pour la vidéosurveillance embarquée. Elle concerne une cartouche de stockage amovible comportant des pions de centrage permettant le guidage de sa connexion avec un châssis récepteur. Elle concerne également un procédé de stockage de données de vidéosurveillance utilisant une telle cartouche.

La vidéosurveillance est couramment utilisée comme moyen de surveillance de sites collectifs ou critiques. A l'heure actuelle, les systèmes de vidéosurveillance sont généralement au moins constitués des éléments suivants :
- un ensemble de caméras vidéo analogiques ou numériques,
- une console de vidéosurveillance comportant notamment des écrans de visualisation pour visionner les données vidéo des différentes caméras, et
- un réseau de communication entre les caméras vidéo et la console de vidéosurveillance.
Lorsque les caméras vidéo sont analogiques, elles peuvent être associées à des encodeurs numériques afin de convertir les données vidéo dans un format numérique.

Les systèmes de vidéosurveillance peuvent également comporter un dispositif d'enregistrement vidéo afin de conserver puis de pouvoir exploiter les données vidéo, par exemple en cas d'investigation policière ou de réquisition judiciaire. Les données vidéo enregistrées doivent pouvoir être exploitées à partir de la console de vidéosurveillance, mais aussi à partir d'une station de lecture. Ainsi, les données vidéo sont généralement enregistrées sur des cartouches de disque amovible. Une telle cartouche comporte un boîtier, un ou plusieurs disques durs enchâssés dans le boîtier et un connecteur fixé sur une face externe du boîtier et permettant de connecter les disques durs à un dispositif externe de lecture-écriture. Le boîtier et le connecteur sont prévus de manière à permettre l'insertion de la cartouche dans un châssis récepteur et son retrait. Le châssis récepteur peut être celui d'une console de vidéosurveillance ou d'une station de lecture.

La vidéosurveillance peut être utilisée aussi bien pour des infrastructures fixes telles qu'un bâtiment ou une place publique que pour des plates-formes mobiles. Par plate-forme mobile, on entend notamment les moyens de transport public, comme les rames et les voitures de transport ferroviaire, les bus, les avions et les ferries. La conception de systèmes embarqués sur une plate-forme mobile impose la prise en compte de contraintes spécifiques, notamment la consommation électrique, l'encombrement, la résistance aux chocs et aux vibrations, la plage de températures d'utilisation, de même que la compatibilité électromagnétique. Le milieu ferroviaire est un milieu très contraignant d'un point de vue compatibilité électromagnétique. Les motrices et les voitures sont soumises à des arcs fréquents entre la caténaire et le pantographe, à des tensions élevées et à des commutations de courant importantes. De plus, dans un même train, les différentes voitures peuvent être soumises à des potentiels de référence différents. Les systèmes embarqués doivent donc être protégés et isolés de cet environnement. A cet effet, l'une des contraintes imposées aux systèmes embarqués dans un train est de séparer les masses électriques des masses mécaniques. Cette contrainte s'applique notamment aux systèmes de vidéosurveillance, et en particulier aux dispositifs d'enregistrement vidéo. Un dispositif d'enregistrement vidéo conventionnel comporte habituellement un disque dur dit grand public. La carcasse d'un tel disque dur comporte des surfaces métalliques dont le potentiel est considéré comme étant la masse mécanique. Cette masse mécanique est confondue avec la masse électrique du disque dur. Autrement dit, il n'existe pas d'isolation électrique entre la masse électrique et la masse mécanique d'un disque dur grand public. Afin de permettre l'utilisation de ces disques durs, il est possible de prévoir une isolation entre la carcasse du disque dur et le boîtier de la cartouche, autrement dit entre la masse électrique du disque dur et la masse mécanique de la cartouche. Cependant, il est nécessaire de relier électriquement, d'une part, la masse mécanique de la cartouche à la masse mécanique du châssis récepteur et, d'autre part, la masse électrique du disque dur à la masse électrique du châssis récepteur. Les connecteurs des masses électrique et mécanique doivent répondre à la fois aux contraintes liées aux systèmes embarqués et à celles découlant du caractère amovible de la cartouche. En l'occurrence, ils doivent résister aux chocs et aux vibrations, avoir un encombrement minimal et être adaptés à des connexions et déconnexions répétées.

Le document US 5 269 698 A décrit une cartouche de stockage amovible comprenant deux pions de centrage permettant de guider mécaniquement la cartouche lors de son insertion dans un châssis récepteur.

Un but de l'invention est notamment de proposer une solution fiable et peu onéreuse pour relier isolément la masse mécanique d'une cartouche de disque amovible à la masse mécanique d'un châssis récepteur et la masse électrique du disque dur de la cartouche à la masse électrique du châssis récepteur. A cet effet, l'invention repose sur l'utilisation, pour la connexion des deux masses, de guides de centrage permettant de rigidifier la liaison mécanique entre le connecteur de la cartouche et le connecteur du châssis récepteur. Plus précisément, l'invention a pour objet une cartouche de stockage amovible comportant un boîtier dans lequel est enchâssé un support de stockage, un connecteur de cartouche relié à un connecteur du support de stockage, et deux pions de centrage, la cartouche étant apte à être glissée selon un axe dans un châssis récepteur comportant un connecteur apte à être connecté au connecteur de cartouche selon l'axe et une encoche pour chaque pion de centrage, les encoches étant aptes à recevoir chacune un pion de centrage de manière à permettre le guidage selon l'axe de la connexion entre le connecteur de cartouche et le connecteur du châssis récepteur, la cartouche étant caractérisée en ce qu'un premier pion de centrage est relié électriquement à une masse mécanique de la cartouche et en ce qu'un deuxième pion de centrage est relié électriquement à une masse électrique de la cartouche, les premier et deuxième pions de centrage étant isolés électriquement l'un de l'autre.

L'invention a notamment pour avantage qu'elle permet de réaliser la connexion des masses mécanique et électrique sans nécessiter de pièce supplémentaire.

Selon des formes particulières de réalisation :
- la masse électrique de la cartouche est reliée électriquement à une masse électrique du support de stockage ;
- une masse mécanique du support de stockage est isolée électriquement de la masse mécanique de la cartouche ;
- la masse mécanique du support de stockage est isolée électriquement de la masse mécanique de la cartouche par une plaque d'isolation, une première face de la plaque d'isolation étant fixée au boîtier de la cartouche, et le support de stockage étant fixé à une deuxième face de la plaque d'isolation ;
- le support de stockage est un disque dur ;
- le connecteur de cartouche est un connecteur de type D-sub ;
- le connecteur de cartouche est relié à un connecteur du support de stockage par une interface de type S-ATA.

L'invention a également pour objet un système de vidéosurveillance embarqué comportant un châssis récepteur et une cartouche telle que décrite précédemment, le châssis récepteur comprenant un dispositif de lecture-écriture de données aptes à être stockées dans le support de stockage de la cartouche, un connecteur apte à être connecté au connecteur de cartouche selon l'axe et une encoche pour chaque pion de centrage de la cartouche, les encoches étant aptes à recevoir chacune un pion de centrage de manière à permettre le guidage selon l'axe de la connexion entre le connecteur de cartouche et le connecteur du châssis récepteur.

L'invention a aussi pour objet un procédé de stockage de données de vidéosurveillance, dans lequel une cartouche selon l'invention est utilisée pour le stockage des données de vidéosurveillance.

Des données de contexte relatives aux données de vidéosurveillance peuvent être stockées avec les données de vidéosurveillance.

L'invention sera mieux comprise et d'autres avantages apparaîtront à la lecture de la description qui va suivre, faite en regard de dessins annexés sur lesquels :
- les figures 1 et 2 représentent, dans des vues en perspective, un exemple de cartouche de stockage amovible selon l'invention apte à être insérée dans un châssis récepteur ;
- la figure 3 représente, dans une vue en perspective, la cartouche de stockage amovible des figures 1 et 2 sans son capot supérieur ;
- la figure 4 représente schématiquement un ensemble comportant la cartouche de stockage amovible des figures 1 à 3 et le châssis récepteur.

La suite de la description est faite en rapport à une cartouche de stockage amovible pour l'enregistrement de données de vidéosurveillance sur une plate-forme mobile. La cartouche de stockage peut néanmoins être utilisée pour l'enregistrement de tous types de données et pour tous types d'infrastructure nécessitant une séparation des masses mécaniques et électriques. En particulier, la cartouche de stockage peut stocker des données de contexte relatives aux données de vidéosurveillance, telles que la date, la localisation de la plate-forme mobile et son itinéraire prévu.

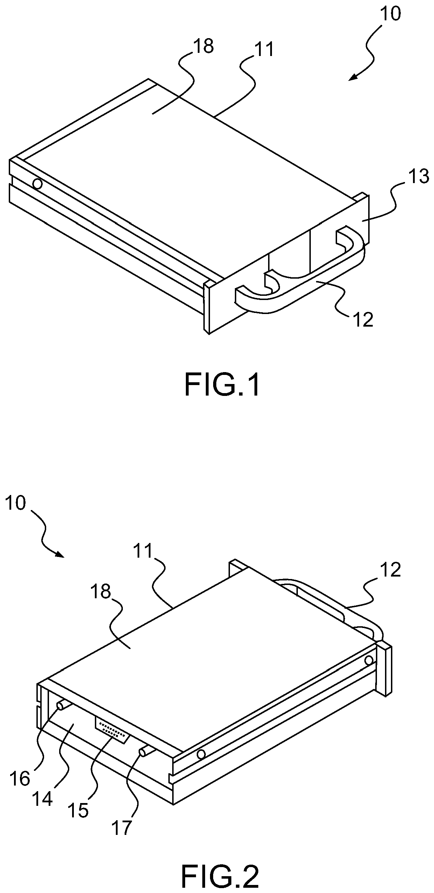

Les figures 1 et 2 représentent, dans des vues en perspective, un exemple de cartouche de stockage amovible selon l'invention. La cartouche de stockage amovible 10 comporte notamment un boîtier 11, par exemple métallique, destiné à pouvoir être inséré dans un châssis récepteur, non représenté. Le boîtier 11 peut être équipé sur une première face externe d'une poignée 12 permettant la manipulation de la cartouche 10. Cette première face externe correspond par exemple à la face avant 13 du boîtier 11, autrement dit à la face visible lorsque le boîtier 11 est inséré dans le châssis récepteur. Le boîtier 11 est également équipé sur une deuxième face externe, appelée face arrière 14, d'un connecteur de cartouche 15. Le connecteur 15 est par exemple un connecteur de type D-sub. Il permet de connecter la cartouche 10 au châssis récepteur pour le transfert de données entre un support de stockage de la cartouche, non représenté, et un dispositif du châssis récepteur. Le boîtier 11 peut avoir la forme générale d'un parallélépipède ou, plus généralement, toute forme permettant de réaliser une liaison glissière entre le boîtier 11 et le châssis récepteur. Le châssis récepteur peut alors être muni d'un connecteur de forme complémentaire au connecteur 15, de manière à permettre sa connexion avec le connecteur 15 lors de l'insertion de la cartouche 10 dans le châssis récepteur. Bien entendu, le connecteur 15 ne comporte pas nécessairement de vis de serrage. En raison du caractère amovible de la cartouche 10, un ajustement avec jeu doit être prévu entre le boîtier 11 et le châssis récepteur. Lorsque la cartouche 10 est soumise à des accélérations ou à des vibrations, ce jeu entraîne l'application d'efforts sur le connecteur de cartouche 15 pouvant l'endommager. Il peut en résulter des interruptions momentanées ou irréversibles des liaisons électriques du connecteur 15 permettant le transfert des données. Dans le but de limiter les efforts sur le connecteur 15, il est possible de disposer des pions de centrage 16, 17 sur une face externe du boîtier 11 et des encoches dans le châssis récepteur, aptes à coopérer avec les pions de centrage 16, 17, de manière à guider la connexion entre le connecteur de cartouche 15 et le connecteur du châssis récepteur. Ainsi, les pions de centrage 16, 17 et les encoches associées forment un ajustement avec un jeu ajusté entre le connecteur de cartouche 15 et le connecteur du châssis récepteur. Les pions de centrage 16, 17 sont par exemple disposés sur la face arrière 14 recevant le connecteur de cartouche 15. Ils peuvent être disposés de part et d'autre du connecteur de cartouche 15. Avantageusement, les pions de centrage 16, 17 sont dimensionnés de manière à venir s'emboîter dans les encoches du châssis récepteur en fin de translation de la cartouche 10 dans le châssis récepteur. Ils peuvent également être dimensionnés de manière à venir en contact avec les encoches préalablement à la connexion entre le connecteur de cartouche 15 et le connecteur du châssis récepteur. Ainsi, le guidage mécanique de la connexion des connecteurs peut être réalisé essentiellement par les pions de centrage 16, 17 et, dans une moindre mesure, par les connecteurs eux-mêmes. Les connecteurs sont donc préservés lors des insertions et des retraits de la cartouche 10 du châssis récepteur. Selon l'invention, les pions de centrage 16, 17 sont également utilisés comme connecteurs de la masse mécanique et de la masse électrique de la cartouche de stockage amovible 10. Les pions de centrage 16, 17 sont donc isolés électriquement l'un de l'autre.

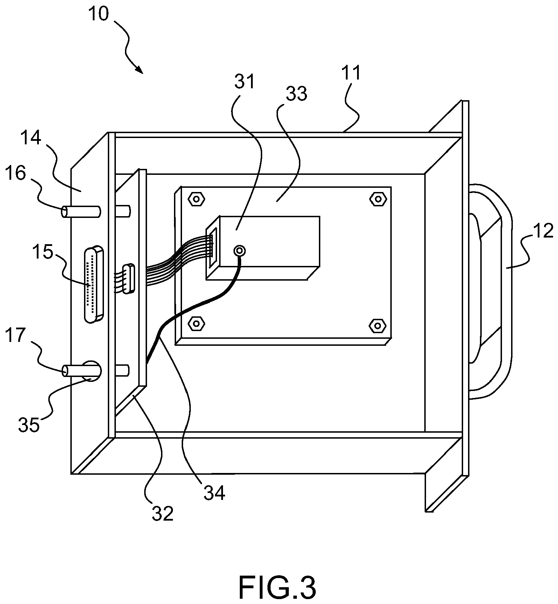

La figure 3 représente, dans une vue en perspective, la cartouche de stockage amovible 10 des figures 1 et 2 avec la face supérieure 18 du boîtier 11 ôtée. Sur cette figure 3, il apparaît que la cartouche 10 comporte un disque dur 31 et une plaque de circuit imprimé 32. Le support de stockage peut également consister en plusieurs disques durs. Lorsque le support de stockage de la cartouche est un disque dur, la cartouche 10 est communément désignée par les termes "cartouche de disque amovible" ou "cartouche de disque". La cartouche 10 peut néanmoins comporter tout type de support de stockage, par exemple une ou plusieurs mémoires vives et leur dispositif de lecture-écriture associé. Dans la mesure où la masse mécanique du disque dur 31 n'est pas isolée électriquement de sa masse électrique, le disque dur 31 doit être isolé électriquement du boîtier 11. L'isolation peut être réalisée par une plaque d'isolation 33, le disque dur 31 étant alors fixé au boîtier 11 par l'intermédiaire de la plaque d'isolation 33. La plaque d'isolation 33 est par exemple une plaque époxy. Le disque dur 31 est relié électriquement à la plaque de circuit imprimé 32, par exemple par une interface S-ATA, laquelle est reliée électriquement au connecteur de cartouche 15 de manière à permettre le transfert de données entre le disque dur 31 et un dispositif de lecture-écriture du châssis récepteur. Le disque dur 31 peut être relié directement au connecteur de cartouche 15. Un premier pion de centrage 16 est relié électriquement à la masse mécanique de la cartouche 10, par exemple au niveau de la face arrière 14 du boîtier 11. Le pion de centrage 16 peut avantageusement s'étendre à l'intérieur du boîtier 11 de manière à permettre la fixation de la plaque de circuit imprimé 32 au boîtier 11. Le deuxième pion de centrage 17 est relié électriquement à la masse électrique de la cartouche 10. En l'occurrence, la masse électrique de la cartouche 10 correspond à la masse électrique du disque dur 31. Cette masse électrique étant au même potentiel que la masse mécanique du disque dur 31, le pion de centrage 17 peut être relié électriquement à la carcasse du disque dur 31, par exemple par un fil électrique 34. Alternativement, le deuxième pion de centrage 17 peut être relié à la masse électrique de la cartouche 10 par l'interface du disque dur 31. Lorsque le pion de centrage 17 est dimensionné de manière à venir en contact avec son encoche associée préalablement à la connexion entre le connecteur de cartouche 15 et le connecteur du châssis récepteur, il permet une préconnexion de la masse électrique du disque dur 31 à la masse électrique du châssis récepteur, le connecteur de cartouche 15 n'établissant qu'ensuite les liaisons +5V et les connexions de masse électrique standard, ces contacts présentant généralement une meilleure qualité de connexion. La préconnexion des masses électriques est garantie par l'ajustement des pièces mâle et femelle (par exemple 0,05mm de jeu seulement entre le connecteur de cartouche 15 et le pion de centrage 17). Selon une forme particulière de réalisation, représentée à la figure 3, le pion de centrage 17 est fixé à la plaque de circuit imprimé 32. Dans le cadre de l'invention, la masse mécanique et la masse électrique de la cartouche 10 sont isolées l'une de l'autre. Cela implique notamment d'isoler le pion de centrage 17 de la masse mécanique de la cartouche 10. L'isolation du pion de centrage 17 peut être réalisée de façon simple en prévoyant une lumière 35 dans le boîtier 11 de sorte que le pion de centrage 17 ne soit pas en contact avec le boîtier 11 ou avec une quelconque partie métallique de la cartouche 10. Le pion de centrage 17 peut alternativement être entouré au niveau du boîtier 11 d'un matériau isolant électriquement de manière à préserver la liaison mécanique entre le pion de centrage 17 et la face arrière 14 du boîtier 11.

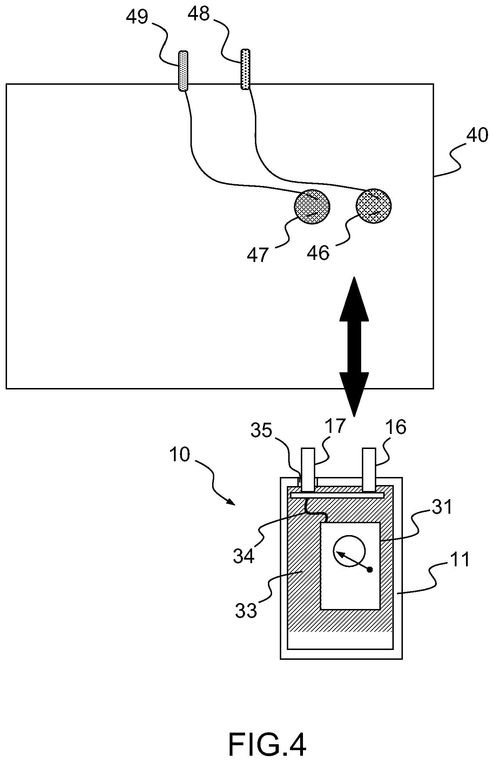

La figure 4 représente schématiquement un ensemble comportant la cartouche de stockage amovible 10 des figures 1 à 3 et un châssis récepteur 40 apte à recevoir la cartouche 10. Le châssis récepteur 40 comporte deux encoches 46 et 47 dimensionnées et disposées de manière à permettre de recevoir les pions de centrage 16 et 17, respectivement. Ces encoches 46, 47 sont normalement isolées électriquement l'une de l'autre et peuvent être respectivement reliées à des connecteurs 48, 49 permettant de relier entre elles les masses mécaniques et électriques de différents systèmes embarqués. Lorsque le châssis récepteur n'est pas embarqué ou, plus généralement, lorsque les masses mécanique et électrique ne nécessitent pas d'être isolées l'une de l'autre, elles peuvent être court-circuitées, par exemple au niveau des encoches 46, 47.

## Revendications

1. Cartouche de stockage amovible comportant
un boîtier (11) dans lequel est enchâssé un support de stockage (31) ledit support de stockage étant pourvu d'une carcasse métallique formant la masse mécanique dudit support de stockage ;
un connecteur de cartouche (15) relié à un connecteur du support de stockage (31), et
deux pions de centrage (16, 17),
la cartouche (10) étant apte à être glissée selon un axe dans un châssis récepteur (40) comportant un connecteur apte à être connecté au connecteur de cartouche (15) selon l'axe et une encoche (46, 47) pour chaque pion de centrage, les encoches (46, 47) étant aptes à recevoir chacune un pion de centrage (16, 17) de manière à permettre le guidage selon l'axe de la connexion entre le connecteur de cartouche (15) et le connecteur du châssis récepteur,
la cartouche (10) étant **caractérisée**
**en ce qu'**un premier pion de centrage (16) est relié électriquement à une masse mécanique de la cartouche (10) et en ce qu'un deuxième pion de centrage (17) est relié électriquement à une masse électrique du support de stockage, les premier et deuxième pions de centrage (16, 17) étant isolés électriquement l'un de l'autre ;
et **en ce que** la masse électrique du support de stockage est isolée de la masse mécanique du support de stockage ou en ce que la carcasse métallique formant la masse mécanique du support de stockage est électriquement isolée du boitier (11).

2. Cartouche selon la revendication 1, dans laquelle une masse mécanique du support de stockage (31) est isolée électriquement de la masse mécanique de la cartouche (10).

3. Cartouche selon la revendication 2, dans laquelle la masse mécanique du support de stockage (31) est isolée électriquement de la masse mécanique de la cartouche (10) par une plaque d'isolation (33), une première face de la plaque d'isolation (33) étant fixée au boîtier (11) de la cartouche, et le support de stockage (31) étant fixé à une deuxième face de la plaque d'isolation (33).

4. Cartouche selon l'une des revendications précédentes, dans laquelle le support de stockage est un disque dur (31).

5. Cartouche selon l'une des revendications précédentes, dans laquelle le connecteur de cartouche (15) est un connecteur de type D-sub.

6. Cartouche selon l'une des revendications précédentes, dans laquelle le connecteur de cartouche (15) est relié à un connecteur du support de stockage (31) par une interface de type S-ATA.

7. Système de vidéosurveillance embarqué comportant un châssis récepteur (40) et une cartouche (10) selon l'une des revendications précédentes, le châssis récepteur (40) comprenant un dispositif de lecture-écriture de données aptes à être stockées dans le support de stockage (31) de la cartouche (10), un connecteur apte à être connecté au connecteur de cartouche (15) selon l'axe et une encoche (46, 47) pour chaque pion de centrage de la cartouche (10), les encoches (46, 47) étant aptes à recevoir chacune un pion de centrage (16, 17) de manière à permettre le guidage selon l'axe de la connexion entre le connecteur de cartouche (15) et le connecteur du châssis récepteur.

8. Procédé de stockage de données de vidéosurveillance, dans lequel une cartouche (10) selon l'une des revendications 1 à 7 est utilisée pour le stockage des données de vidéosurveillance.

9. Procédé selon la revendication 8, dans lequel des données de contexte relatives aux données de vidéosurveillance sont stockées avec les données de vidéosurveillance.

## Patentansprüche

1. Abnehmbare Speicherkassette, umfassend
ein Gehäuse (11), in dem ein Speicherträger (31) eingefügt ist, wobei der Speicherträger über ein Metallgerüst verfügt, das die mechanische Masse des Speicherträgers bildet;
einen Kassettenanschluss (15), der mit einem Anschluss des Speicherträgers (31) verbunden ist, und
zwei Zentrierzapfen (16, 17),
wobei die Kassette (10) gemäß einer Achse in ein Aufnahmegestell (40) geschoben werden kann, das einen Anschluss umfasst, der am Kassettenanschluss (15) gemäß der Achse angeschlossen werden kann, und einer Nut (46, 47) für jeden Zentrierzapfen, wobei die Nuten (46, 47) jeweils einen Zentrierzapfen (16, 17) aufnehmen können, um die Führung gemäß der Achse des Anschlusses zwischen dem Kassettenanschluss (15) und dem Anschluss des Aufnahmegestells zu ermöglichen,
wobei die Kassette (10) **dadurch gekennzeichnet ist,**
**dass** ein erster Zentrierzapfen (16) elektrisch mit einer mechanischen Masse der Kassette (10) verbunden ist, und dass ein zweiter Zentrierzapfen (17) elektrisch mit einer elektrischen Masse des Speicherträger verbunden ist, wobei der erste und zweite Zentrierzapfen (16, 17) elektrisch voneinander isoliert sind;
und **dass** die elektrische Masse des Speicherträgers von der mechanischen Masse des Speicherträgers isoliert ist, oder dass das Metallgerüst, das die mechanische Masse des Speicherträgers bildet, elektrisch vom Gehäuse (11) isoliert ist.

2. Kassette nach Anspruch 1, wobei eine mechanische Masse des Speicherträgers (31) elektrisch von der mechanischen Masse der Kassette (10) isoliert ist.

3. Kassette nach Anspruch 2, wobei die mechanische Masse des Speicherträgers (31) durch eine Isolierplatte (33) elektrisch von der mechanischen Masse der Kassette (10) isoliert ist, wobei eine erste Seite der Isolierplatte (33) am Gehäuse (11) der Kassette befestigt ist, und der Speicherträger (31) an einer zweiten Seite der Isolierplatte (33) befestigt ist.

4. Kassette nach einem der vorherigen Ansprüche, wobei der Speicherträger eine Festplatte (31) ist.

5. Kassette nach einem der vorherigen Ansprüche, wobei der Kassettenanschluss (15) ein Anschluss vom Typ D-Sub ist.

6. Kassette nach einem der vorherigen Ansprüche, wobei der Kassettenanschluss (15) mit einem Anschluss des Speicherträgers (31) über eine Schnittstelle vom Typ S-ATA verbunden ist.

7. Bord-Videoüberwachungssystem, umfassend ein Aufnahmegestell (40) und eine Kassette (10) nach einem der vorherigen Ansprüche, das Aufnahmegestell (40) umfassend eine Vorrichtung zum Lesen-Schreiben von Daten, die im Speicherträger (31) der Kassette (10) gespeichert werden können, einen Anschluss, der am Kassettenanschluss (15) gemäß der Achse angeschlossen werden kann, und einer Nut (46, 47) für jeden Zentrierzapfen der Kassette (10), wobei die Nuten (46, 47) jeweils einen Zentrierzapfen (16, 17) aufnehmen können, um die Führung gemäß der Achse des Anschlusses zwischen dem Kassettenanschluss (15) und dem Anschluss des Aufnahmegestells zu ermöglichen.

8. Speicherverfahren von Videoüberwachungsdaten, wobei eine Kassette (10) nach einem der Ansprüche 1 bis 7 zum Speichern der Videoüberwachungsdaten verwendet wird.

9. Verfahren nach Anspruch 8, wobei die Kontextdaten in Bezug auf die Videoüberwachungsdaten mit den Videoüberwachungsdaten gespeichert werden.

## Claims

1. A removable storage cartridge comprising
a housing (11) in which is encased a storage medium (31), said storage medium being provided with a metal carcass forming the mechanical ground of said storage medium;
a cartridge connector (15) linked to a connector of the storage medium (31), and
two centring pins (16, 17),
the cartridge (10) being able to be slid along an axis in a receiver chassis (40) comprising a connector able to be connected to the cartridge connector (15) along the axis and a notch (46, 47) for each centring pin, the notches (46, 47) each being able to receive a centring pin (16, 17) so as to allow guidance along the axis of the connection between the cartridge connector (15) and the connector of the receiver chassis,
the cartridge (10) being **characterised**
**in that** a first centring pin (16) is linked electrically to a mechanical ground of the cartridge (10) and in that a second centring pin (17) is linked electrically to an electrical ground of the storage medium, the first and the second centring pins (16, 17) being electrically insulated from one another;
and **in that** the electrical ground of the storage medium is insulated from the mechanical ground of the storage medium
or in that the metal carcass forming the mechanical ground of the storage medium is electrically insulated from the housing (11).

2. The cartridge according to claim 1, wherein a mechanical ground of the storage medium (31) is electrically insulated from the mechanical ground of the cartridge (10).

3. The cartridge according to claim 2, wherein the mechanical ground of the storage medium (31) is electrically insulated from the mechanical ground of the cartridge (10) by an insulation board (33), a first face of the insulation board (33) being fixed to the housing (11) of the cartridge, and the storage medium (31) being fixed to a second face of the insulation board (33).

4. The cartridge according to any of the preceding claims, wherein the storage medium is a hard disc (31).

5. The cartridge according to any of the preceding claims, wherein the cartridge connector (15) is a connector of the D-sub type.

6. The cartridge according to any of the preceding claims, wherein the cartridge connector (15) is linked to a connector of the storage medium (31) by an interface of the S-ATA type.

7. An on-board video-surveillance system comprising a receiver chassis (40) and a cartridge (10) according to any of the preceding claims, the receiver chassis (40) comprising a device for reading/writing data which are able to be stored in the storage medium (31) of the cartridge (10), a connector able to be connected to the cartridge connector (15) along the axis and a notch (46, 47) for each centring pin of the cartridge (10), the notches (46, 47) each being able to receive a centring pin (16, 17) so as to allow guidance along the axis of the connection between the cartridge connector (15) and the connector of the receiver chassis.

8. A method for storing video-surveillance data, wherein a cartridge (10) according to any of claims 1 to 7 is used for the storage of the video-surveillance data.

9. The method according to claim 8, wherein the context data relating to the video-surveillance data are stored with the video-surveillance data.
